# EUROPEAN PATENT APPLICATION

(11) **EP 1 855 365 A1**
(43) Date of publication of application: **14.11.2007**
(21) Application number: 06386009.2
(22) Date of filing: 09.05.2006
(51) Int. Cl.: H02H 9/04, G05F 1/571, H01C 1/16, H01C 7/06, H01C 7/10, H03K 17/30, H05K 5/06

(54) **Overvoltage protection device module and method for forming the same**

(71) Applicant: Raycap Corporation, Maroussi, 15124 Athens (GR)
(72) Inventor: Economou, Spyridon, Halandri, 152 34 Athens (GR); Fragkos, Anastasios, Lykovrisi, 141 23 Athens (GR)
(74) Representative: Papaconstantinou, Helen

(57) **Abstract**

An overvoltage protection device module (100) includes an electronics assembly (105) and a housing (170) containing the electronics assembly. The electronics assembly includes a varistor device (120), a thyristor (140) electrically connected in parallel with the varistor device, and an inductive coil (130) electrically connected to the thyristor. The electronics assembly further includes triggering circuit (150) electrically connected to a gate terminal (149) of the thyristor. The triggering circuit is configured to monitor a voltage (V_{thy}) across the thyristor and selectively provide a triggering current to the gate terminal of the thyristor based on the voltage across the thyristor. Related methods of assembly and operation are also discussed.

## Description

### Field of the Invention

The present invention relates to overvoltage protection devices and, more particularly, to an overvoltage protection device module including a varistor device and a thyristor.

### Background of the Invention

It is well known that electrical circuits may experience surges in power that is supplied to the circuit. These power surges may be caused by a wide variety of circumstances, such as equipment failure and/or lightning strikes. Such surges may occur relatively quickly, leaving little time to respond in a fashion to protect electrical equipment connected to the surging line. Accordingly, voltage limiting devices may be used for protection of electrical circuits and/or other electronic equipment.

Thyristors are solid-state semiconductor switching devices that may be employed in voltage limiting devices to protect electrical circuits and/or other electronic equipment. A thyristor may be activated to conduct current between its main terminals when a current pulse is received at a gate terminal of the thyristor. For example, thyristors may be used in power supplies as a sort of circuit-breaker, or "crowbar", to prevent failure in the power supply from damaging more surge sensitive components. However, when the thyristor is in a deactivated or blocking state, the thyristor may be damaged by high-voltage surges, for example, such as those which may result from lightning strikes. More particularly, if the surge current magnitude and duration exceeds the energy dissipating capability of the thyristor, the thyristor may be destroyed.

Accordingly, it is known to suppress such overvoltages using one or more varistors (*i.e*., voltage-variable non-linear resistors) electrically connected across the main terminals of the thyristors. The electrical resistance of a varistor may switch from a relatively high standby value (for applied voltages of less than a so-called breakover voltage level) to relatively low conducting value (for voltages above the breakover level). More specifically, the varistor has a characteristic clamping voltage such that, responsive to a voltage increase beyond a prescribed voltage, the varistor forms a low resistance shunt path for the overvoltage current that reduces the potential for damage to more sensitive components. Typically, a line fuse may also be provided in a protective circuit, and the line fuse may be blown or weakened by the short-circuit essentially created by the shunt path. Thus, varistors may offer a relatively high degree of non-linearity, switching with negligible delay time (less than 50 nanoseconds), and relatively high energy handling capability. As such, in conventional voltage limiting devices, relatively high overvoltage conditions, such as those generated by lightning, may be limited by the varistor, while relatively lower overvoltage conditions of a relatively greater time duration may be limited by the thyristor.

### Summary of the Invention

According to some embodiments of the present invention, a voltage limiting device includes a varistor device having first and second terminals, a thyristor having first and second terminals respectively electrically connected to the first and second terminals of the varistor device, and a triggering circuit electrically connected to a gate terminal of the thyristor. The triggering circuit is configured to monitor a voltage between the first and second terminals of the thyristor, and selectively provide a triggering current to the gate terminal of the thyristor based on the voltage between the first and second terminals of the thyristor.

According to other embodiments of the present invention, a method of operating a voltage limiting device including a varistor device and a thyristor electrically connected to the varistor device is provided. The method includes monitoring a voltage between first and second terminals of the thyristor, and selectively providing a triggering current to a gate terminal of the thyristor. More particularly, the triggering current is selectively provided to the gate terminal of the thyristor when the voltage between the first and second terminals of the thyristor exceeds a desired triggering voltage.

According to embodiments of the present invention, an overvoltage protection device module includes an electronics assembly and a housing. The electronics assembly includes a varistor device, a thyristor electrically connected in parallel with the varistor device, and an inductive coil electrically connected to the thyristor. The housing contains the electronics assembly. Each of the varistor device, the thyristor and the inductive coil is disposed in the housing.

According to some embodiments of the present invention, an overvoltage protection device module includes an electronics assembly and a housing. The electronics assembly includes a varistor device, and a thyristor electrically connected in parallel with the varistor device. The housing contains the electronics assembly. The housing includes: an inner housing formed of polyurethane encapsulating at least a portion of the electronics assembly; and an outer shell formed of polycarbonate surrounding at least a portion of the inner housing and the electronics assembly.

According to further embodiments of the present invention, an overvoltage protection device module includes an electronics assembly and a housing. The electronics assembly includes a varistor device, and a thyristor electrically connected in parallel with the varistor device. The housing contains the electronics assembly. The housing includes: an inner housing formed of a resin encapsulating at least a portion of the electronics assembly; an outer shell surrounding at least a portion of the inner housing and the electronics assembly; a gas chamber defined between the electronics assembly and the inner housing to accommodate thermal expansion of the inner housing.

According to some embodiments of the present invention, a method for forming an overvoltage protection device module includes: placing an electronics assembly in a shell cavity of a shell such that at least a portion of the electronics assembly is contained therein; introducing a liquid filler resin into the shell cavity between the shell and the electronics assembly; and curing the liquid filler resin to form an inner housing between the shell and the electronics assembly, wherein a gas chamber is defined between the inner housing and the electronics assembly.

Further features, advantages and details of the present invention will be appreciated by those of ordinary skill in the art from a reading of the figures and the detailed description of the preferred embodiments that follow, such description being merely illustrative of the present invention.

### Brief Description of the Drawings

**Figure 1** is a top, front perspective view of an overvoltage protection device module according to some embodiments of the present invention.

**Figure 2** is a bottom, rear perspective view of the overvoltage protection device module of **Figure 1.**

**Figure 3** is an exploded, perspective view of the overvoltage protection device module of **Figure 1,** wherein an inner housing of the overvoltage protection device module is not shown.

**Figure 4** is a perspective view of an electronic assembly and a film each forming a part of the overvoltage protection device module of **Figure 1**.

**Figure 5** is a cross-sectional view of the overvoltage protection device module of **Figure 1** taken along the line 5-5 of **Figure 1.**

**Figure 6** is a cross-sectional view of the overvoltage protection device module of Figure 1 taken along the line 6-6 of **Figure 5.**

**Figure 7** is a cross-sectional view of a varistor device forming a part of the overvoltage protection device module of **Figure 1**.

**Figure 8** is a schematic diagram illustrating an overvoltage protection circuit which may be employed in an overvoltage protection device module according to some embodiments of the present invention.

**Figure 9** is a schematic diagram further illustrating the overvoltage protection circuit of **Figure 8** and related methods of operation according to some embodiments of the present invention.

**Figure 10** is a schematic diagram illustrating an alternate overvoltage protection circuit and related methods of operation according to further embodiments of the present invention.

**Figure 11** is a graph illustrating an exemplary variation of the desired triggering voltage as a function of temperature as may be provided by overvoltage protection circuits in accordance with some embodiments of the present invention.

### Detailed Description of Embodiments of the Invention

The present invention now will be described more fully hereinafter with reference to the accompanying drawings, in which illustrative embodiments of the invention are shown. In the drawings, the relative sizes of regions or features may be exaggerated for clarity. This invention may, however, be embodied in many different forms and should not be construed as limited to the embodiments set forth herein; rather, these embodiments are provided so that this disclosure will be thorough and complete, and will fully convey the scope of the invention to those skilled in the art.

It will be understood that when an element is referred to as being "coupled" or "connected" to another element, it can be directly coupled or connected to the other element or intervening elements may also be present. In contrast, when an element is referred to as being "directly coupled" or "directly connected" to another element, there are no intervening elements present. Like numbers refer to like elements throughout.

In addition, spatially relative terms, such as "under", "below", "lower", "over", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "under" or "beneath" other elements or features would then be oriented "over" the other elements or features. Thus, the exemplary term "under" can encompass both an orientation of over and under. The device may be otherwise oriented (rotated 90 degrees or at other orientations) and the spatially relative descriptors used herein interpreted accordingly.

As used herein the expression "and/or" includes any and all combinations of one or more of the associated listed items. The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "wafer" means a substrate having a thickness which is relatively small compared to its diameter, length or width dimensions.

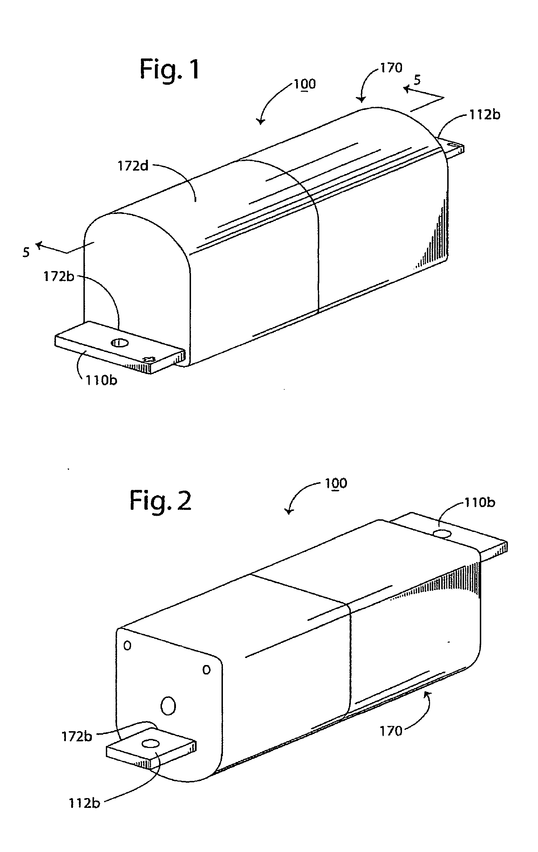

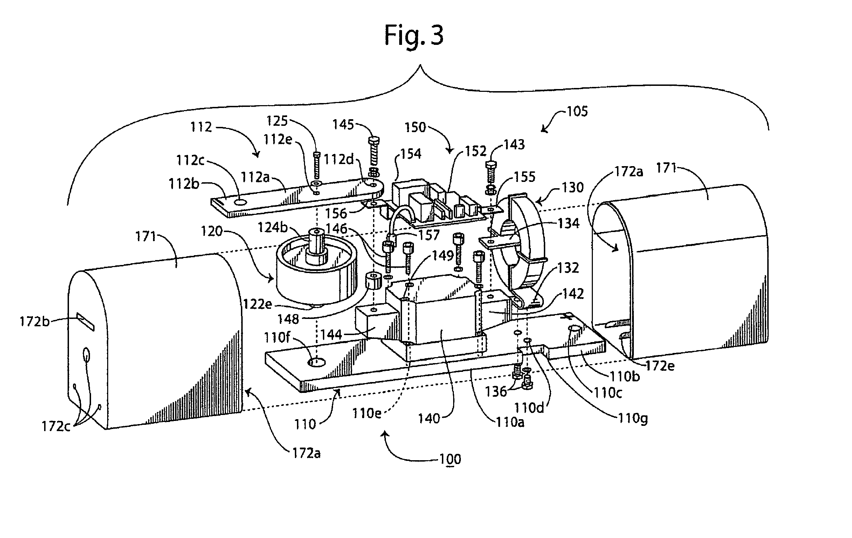

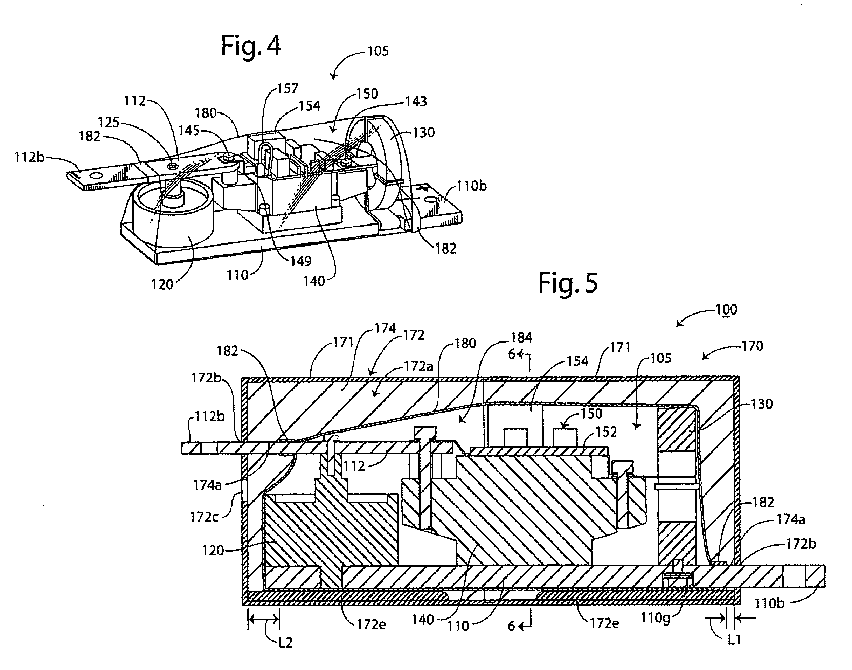

With reference to **Figures 1-10,** an integrated overvoltage protection device module **100** according to embodiments of the present invention is shown therein. The module **100** includes an electronics assembly **105** (*see, e.g.,* **Figures 3** and **4)** and a housing assembly **170 (Figures 1-3, 5** and **6).** The electronics assembly **105** includes a positive pole plate **110,** a negative pole plate **112,** a varistor device **120,** an inductive coil **130,** a thyristor **140** and a triggering circuit assembly **150**. The housing assembly **170** encapsulates the electronics assembly **105.**

The module **100** may be used to protect personnel against touch and accessible voltages used, for example, in rail traction systems, as well as to protect telecommunications and/or other electronic equipment from overvoltages. For example, the overvoltage protection device module **100** may be installed between the current return path and electrical equipment and/or other conductive structures adjacent to the rails in a rail traction system. In the case of overvoltage, the overvoltage protection device module **100** may provide a durable conductive path between the overloaded area and a substation. More particularly, overvoltages with a time duration of more than about 3 milliseconds may be limited by the thyristor **140,** while higher overvoltages with a time duration of less than a few milliseconds (such as overvoltages generated by lightning) may be limited by the varistor device **120.**

The positive pole plate **110** includes a body portion **110a** and a terminal portion **110b.** A terminal bore **110c** extends through the terminal portion **110b.** A pair of coil bores **110d,** a plurality of thyristor bores **110e,** and a varistor device bore **110f** extend through the body portion **110a.** A slot **110g** is formed in a lateral edge and the bottom of the pole plate **110** between the terminal portion **110b** and the body portion **110a.** In order to not weaken the plate **110,** the slot **110g** does not extend the full width of the plate **110.**

The positive pole plate **110** may be formed of any suitable electrically conductive material. According to some embodiments, the pole plate **110** is formed of a corrosion resistant alloy. According to some embodiments, the pole plate **110** is formed of aluminum or aluminum alloy. The positive pole plate **110** may be formed by any suitable method, such as casting, molding and/or machining.

The negative pole plate **112** includes a body portion **112a** and a terminal portion **110b.** A terminal bore **112c** is formed in the terminal portion **112b**. A thyristor bore **112d** and a varistor device bore **112e** are formed in the body portion **112a.** The negative pole plate **112** may be formed of the same materials and using the same methods as described above with regard to the positive pole plate **110**.

According to some embodiments, the pole plates **110, 112** have a specific heat of at least about 900 Joules/(kg-°K). According to some embodiments, the positive pole plate **110** has a thermal mass of at least about 1750 Joules/K. According to some embodiments, the positive pole plate **110** has a thickness of between about 19.5 and 20.5 mm. According to some embodiments, the negative pole plate **112** has a thermal mass of at least about 198 Joules/K. According to some embodiments, the negative pole plate **112** has a thickness of between about 7.5 and 8.5 mm.

The varistor device **120** can be any suitable varistor device. According to some embodiments, the varistor device **120** is an overvoltage protection device as disclosed in U.S. Patent No. 6,430,020 to Atkins et al., titled "Overvoltage Protection Device Including Wafer of Varistor Material," the disclosure of which is incorporated herein by reference, and/or a Strikesorb™ overvoltage protection device as sold by Raycap Corporation of Greece.

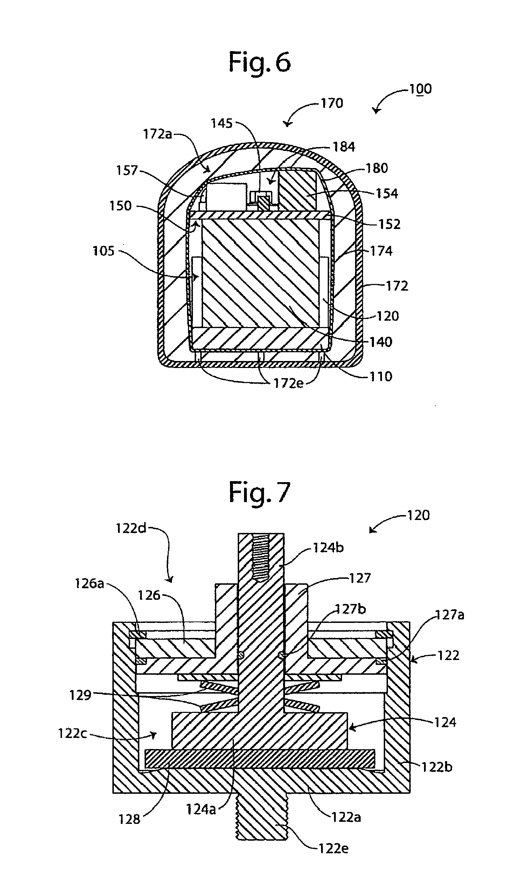

An exemplary varistor device **120** is illustrated in **Figure 7.** The varistor device **120** includes a housing **122,** an electrode member **124,** a spring clip **126a,** a cap **126,** an insulator ring **127,** O-rings **127a, 127b,** a varistor wafer **128,** and spring washers **129**. According to some embodiments, the housing **122** is an integral, unitarily formed housing. The housing **122** includes an endwall **122a** and a sidewall **122b** defining a cavity **122c** and an opening **122d** communicating with the cavity **122c.** A terminal post **122e** extends from the endwall **122a.** The electrode member **124** may also be an integral member that is unitarily formed. The electrode member **124** includes a head **124a** and a shaft **124b.** The cap **126** and the insulator ring **127** are mounted in the cavity **122c** to secure the head **124a** in the cavity **122c.** A collar portion of the insular ring **127** extends up through a hole in the cap **126**. The shaft **124b** extends up through the hole in the cap **126** and a hole in the insulator ring **127**. The spring washers load the electrode head **124a** against the wafer **128.**

According to some embodiments, the housing **122** and the electrode member **124** are formed of metal. According to some embodiments, the housing **122** and the electrode member **124** are formed of aluminum or aluminum alloy. According to some embodiments, the insulator ring **127** is formed of an electrically insulative polymeric material having a high melting temperature such as polycarbonate. According to some embodiments, the varistor wafer **128** is formed of a metal oxide varistor (MOV) material.

The housing **122** is electrically connected with and mechanically secured to the positive pole plate **110** by the terminal post **122e,** which may threadily engage the bore **110f.** The shaft **124b** of the electrode member **124** is electrically connected with and mechanically secured to the negative pole plate **112** by a bolt **125** that extends through the bore **112e.** Notably, the external surface of the endwall **122e** of the housing **122** may abut the positive pole plate **110,** providing a substantial contact area therebetween.

The inductive coil **130** may be any suitable inductive coil device. Suitable inductive coils may include air cored coils, iron cored coils, or ferrite cored coils. The coil **130** has a positive terminal **132** and a negative terminal **134.** The coil **130** is electrically connected and mechanically secured to the positive pole plate **110** by the terminal **132,** which extends through the slot **110g** and is held to the underside of the plate **110** by bolts **136.** An electrolytic tin coating may be applied to the terminal **132.**

The thyristor **140** may be any suitable thyristor device. Suitable thyristor devices may include power thryistor modules or hockey puck thyristors. The thyristor **140** has a first main terminal **142** and a second main terminal **144.** According to some embodiments of the present invention and as described hereinafter, the first main terminal **142** may be a positive terminal, and the second main terminal **144** may be a negative terminal. The positive terminal **142** is directly electrically connected to the negative terminal **134** of the coil **130** by a bolt **143.** The negative terminal **144** of the thyristor **140** is directly electrically connected to the negative pole plate **112** and to the electrode member shaft 124b of the varistor device **120** by a bolt **145** that extends through the bore **112e** and an aluminum spacer **148** provided between the plate **112** and the terminal **144.** The thyristor **140** has mounting bores and is secured to the positive pole plate **110** by bolts **146** that extend through the mounting bores and into the bores **110e**. The thyristor **140** further includes a gate terminal **149.** The thyristor **140** is configured to conduct current in one direction when an appropriate control or trigger signal is applied to the gate terminal **149.** A thermally conductive paste may be provided between the bottom of the thyristor **140** and the plate **110** to enhance contact and heat transfer therebetween.

The triggering circuit assembly **150** includes a printed circuit board (PCB) **152,** a positive terminal tab **155,** a negative terminal tab **156,** a jumper cable **157,** and a capacitor **154.** The terminals **155, 156** may be metal (*e.g*., tin coated copper) sheets that are welded to the PCB **152.** The terminal **155** overlies the thyristor positive terminal **132** and is secured thereto by the bolt **143.** The terminal **156** overlies the thyristor negative terminal **144** and is secured thereto by the bolt **145.** The PCB **152** is thereby flexibly or displaceably mounted or suspended over the thyristor **140.** The jumper cable **157** is received in a connector socket or otherwise connected to the gate terminal **149** of the thyristor **140.** The construction and operation of the triggering circuit assembly **150** is described in more detail below.

With reference to **Figures 1-3, 5** and **6,** the housing assembly **170** includes a shell **172,** an inner housing **174** (not shown in **Figure 3),** and a barrier film **180**. A gas chamber **184** is defined within the film **180** as described below. For the purpose of explanation and clarity, the components of the electronic components assembly **105** are shown in cross-section as solid objects in **Figures 5** and **6.** However, it will be appreciated that these components may in fact include various subcomponents, etc.

The shell **172** includes two shell parts **171** that define a shell cavity **172a.** Opposed slots or end openings **172b** communicate with the shell cavity **172a.** Additionally, fill holes **172c** are provided in one endwall of the shell **172** and communicate with the shell cavity **172a.** The shell **172** has a convex top surface **172d.** Standoff ribs **172e** project inwardly from the bottom walls of the shell parts **171.** The shell **172** may be otherwise shaped and constructed. For example, according to some embodiments, the shell includes one piece having the shape and dimensions of the overall shell **172** except that an end wall thereof is separable to serve as a removable cover to permit insertion of the electronic components assembly 105.

The shell **172** may be formed of any suitable rigid material. According to some embodiments, the shell **172** is formed of a UV resistant material. According to some embodiments, the shell **172** has a flame resistance of at least about V-0, 3 mm flammability class UL94 and good electrical isolation properties with comparative tracking index V > 200 (IEC 60112). According to some embodiments, the shell **172** is formed of a thermoplastic material. According to some embodiments, the shell **172** is formed of polycarbonate.

The inner housing **174** is disposed in the shell cavity **172a,** An outer surface of the inner housing **174** may contact and be bonded with the inner surface of the shell **172.** The inner surface of the inner housing **174** defines an inner housing cavity within the shell cavity **172a.** The inner housing **174** has opposed end openings **174a** through which the terminal portions **110b, 112b** extend. The inner housing **174** forms a seal about and is bonded with the positive pole plate **110** and the negative pole plate **112** adjacent the terminal portions **110b**, **112b**.

The inner housing **174** may be formed of any suitable electrically insulating material. According to some embodiments, the inner housing **174** is formed of a polymeric resin. According to some embodiments, the inner housing **174** is formed of a water impermeable polymeric material. According to some embodiments, the inner housing **174** is formed of polyurethane.

The film **180** is disposed in the inner housing cavity and surrounds the electronic components **120, 130, 140, 150** and portions of the pole plates **110, 112** interior of the terminal portions **110b, 112b**. According to some embodiments, the film **180** directly engages the inner surface of the inner housing **174.** The film **180** may include multiple superimposed layers. For example, the film **180** may be concentrically wound. The ends of the film **180** are secured in a closed position by suitable securing members such as pieces of self adhesive tape **182.** The film **180** thereby defines a gas chamber **184** within the film **180.** A volume of a suitable gas such as air is contained in the gas chamber **184**.

The film **180** may be any suitable film. According to some embodiments, the film **180** is a flexible organic film. According to some embodiments, the film **180** may be formed of polyethylene. According to some embodiments, the film **180** has a melting temperature of at least 80 °C. According to some embodiments, the total thickness of the film **180** (*i.e.,* including all of the film layers) is between about 0.3 and 0.5 mm.

The gas chamber **184** may be configured such that the film **180** engages some portions of the electronics assembly **105,** such as the positive pole plate **110** and the capacitor **154.** However, according to some embodiments, the gas chamber **184** is configured such that a gap is provided between the inner surface of the inner housing **174** and at least the PCB **152.** According to some embodiments, the width of the gap at these locations is at least about 85 mm. According to some embodiments, the gap width is at least about 100 mm.

The module **100** may be formed as follows in accordance with embodiments of the present invention. The electronics assembly **105** is assembled by mechanically and electrically coupling the varistor device **120,** the coil **130,** the thyristor **140** and the triggering circuit assembly **150** to the pole plates **110, 112** and to each other as described above and as shown in **Figure 4.**

The film **180** is then wrapped around the electronics assembly **105.** The self-adhesive tape pieces **182** are installed to form an airtight enclosure. A volume of air (or other suitable gas) is trapped in the film **180** *(i.e.,* between the film **180** and the electronics assembly **105**).

The shell **172** may be separately pre-formed. According to some embodiments, the shell parts **171** are injection molded.

The preformed shell parts **171** are mounted on the electronics assembly **105** so that the electronic components **120, 130,140, 150** and the film **180** are contained in the shell cavity **172A.** The joint between the opposing open ends of the shell parts **171** may be secured together using a silicone caulk, an adhesive, and/or self-adhesive tape. The shell part or parts **171** may be properly positioned relative to the electronics assembly **105** using a jig or the like.

A liquid filler resin is injected or otherwise introduced through the larger of the fill holes **172c** of the shell **172** into the shell cavity **172a.** The smaller holes **172c** may permit displaced air to escape. The liquid resin flows into the space or chamber defined by the outer surface of the film **180** and the inner surface of the shell **172.** According to some embodiments, the liquid filler resin is introduced until this volume is substantially fully filled. According to some embodiments, the film **180** and tape pieces **182** are positioned such that the liquid filler resin flows about and engages portions of the pole plates **110, 112** on or adjacent the terminal portions 110b, **112b.** Tape or the like may be temporarily placed adjacent the fill holes **172c** to receive resin overflow for convenient removal.

The liquid filler resin is then cured *in situ* within the shell **172** to thereby form the inner housing **174.** The resin may be cured by, for example, heat, UV radiation, microwave radiation, or air. According to some embodiments, the film **180** has a melting temperature greater than the peak temperature attained by the polyurethane resin during the curing process.

The inner housing **174** and the shell **172** cooperate to electrically isolate the terminal portions **110b, 112b** from one another and to environmentally protect the electronics assembly **105** for an extended period in service. More particularly, the polyurethane resin of the inner housing **172** inhibits or prevents water and humidity from entering the electronic components (e.g., the varistor device **120,** the coil **130,** the thyristor **140,** and the triggering circuit assembly **150).** The polyurethane resin seals with the pole plates **110, 112** about or adjacent the terminal portions **110b, 112b** and also seals the joint between the shell parts **171** to fully encapsulate the electronic components. According to some embodiments, the lengths **L1**, **L2 (Figure 5)** of the seals formed by the inner housing **174** about each plate **110, 112** extending from the gas chamber **184** are each at least about 8 mm and, according to some embodiments, between about 8 and 12 mm.

The polyurethane resin material has good anti-static electrical properties so that it does not tend to attract dust, which in the presence of humidity may otherwise create an electrically conductive film on an external surface of the module **100.** Such an electrically conductive film could provide an unintended alternate path for current along the external surface between the terminal portions **110b**, **112b** that bypasses the electronic components. The polycarbonate shell **172** may serve as an ultraviolet (UV) shield to protect the integrity of the polyurethane resin inner housing **174.**

The terminal portions **110b** and **112b** are located at opposite ends of the module **100,** and may also be positioned in spaced apart, opposed top and bottom planes, respectively, as shown. In this way, the distance between the poles is increased to further prevent or inhibit short circuiting of the terminal portions **110b**, **112b** along an unintended external conductive path.

The gas chamber **184** may serve to accommodate expansion of the inner housing **174** and/or the shell **172** in service. Under some conditions, including where the module **100** generates or is exposed to extreme temperatures, the polyurethane inner housing **174** or polycarbonate shell **172** may thermally expand. The film **180** and the gas chamber **184,** which is filled with a compressible gas such as air, accommodates such expansion by preventing or limiting contact or loading between the inner housing **174** and the electronic components **120, 130, 140, 150.** Contact with some or portions of the electronic components may be permitted. For example, the inner surface of the inner housing **174** may be positioned directly adjacent (with the film **180** interposed therebetween) the capacitor **154** if the capacitor **154** is flexibly mounted or sufficiently robust or flexible enough to withstand or accommodate such stresses. For example, the flexible mounting of the PCB **152** via the spring metal terminal tabs **155, 156** may permit the inner housing to displace the capacitor **154** (and thereby the PCB **152)** without damaging the capacitor **154** or the PCB **152.** When the module **100** cools, the inner housing **174** will typically return to its original position, thereby restoring the gas chamber **184.**

The gas chamber **184** may serve to reduce the weight of the module 100. The gas chamber **184** may also serve to reduce the amount of resin (*e.g*., polyurethane resin) required, thereby reducing the cost of manufacturing of the module **100**.

The positive pole plate **110** and/or the negative pole plate **112** may serve as heat sinks during the operation of the module **100.** In particular, the pole plate **110** and/or the pole plate **112** may have relatively high thermal capacities so that they may absorb and dissipate thermal energy or heat generated by the electronics assembly **105** in use. The pole plates **110, 112** may also provide structural integrity to the module **100.**

The external shape or form factor of the housing **170** can be selected to reduce the amount of inner housing resin (*e*.*g*., polyurethane resin) and/or shell thermoplastic (*e.g*., polycarbonate) required, the weight of the module **100,** and the space requirements for the module **100.** For example, as best seen in **Figures 2, 5** and **6,** the lower side of the shell **172** is flat to match the flat shape of the positive pole plate **110** and the top side of the shell **172** is convex to generally approximate the contour of the top side of the electronics assembly **105.**

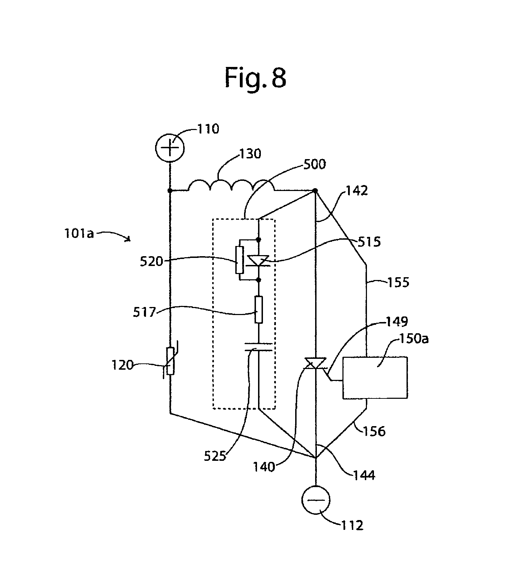

According to some embodiments, overvoltage protection devices according to embodiments of the present invention (*e.g*., the overvoltage protection device **100)** may include an overvoltage protection circuit **101a** as schematically illustrated in **Figure 8.** Referring to **Figure 8,** the overvoltage protection circuit **101a** includes the varistor device **120,** the thyristor **140,** a triggering circuit **150a** (which may be embodied in whole or in part in the triggering circuit assembly **150),** the inductive coil **130,** and a protection network **500.**

As discussed above, the positive main terminal **142** and the negative main terminal **144** of the thyristor **140** are respectively electrically connected to the positive and negative terminals **122e, 124e** of the varistor device **120.** The voltage between the main terminals **142, 144** of the thryistor **140** may be referred to herein as the voltage "across" the thyristor **140,** V_{thy}.

Also, as discussed above, the inductive coil **130** is electrically connected between the positive terminal **142** of the thyristor **140** and the positive terminal **122e** of the varistor device **120.** The inductive coil **130** is configured to limit the current rate-of-change (di/dt) of the device **100,** for example, to a value that is less than the maximum current rate-of-change rating of the thyristor **140.**

The protection network **500** is electrically connected in parallel with the thyristor **140,** and includes a diode **515,** resistors **517** and **519,** and a capacitor **525.** The protection network **500** is configured to limit the voltage rate-of-change (dV/dt) of the device **100** to less than a predetermined value, for example, 250 V/µs.

Still referring to **Figure 8,** the triggering circuit **150a** is electrically connected to the gate terminal **149** of the thyristor **140,** as well as to the first and second main terminals **142, 144** of the thyristor **140.** The triggering circuit **150a** is configured to monitor the voltage V_{thy} between the main terminals **142, 144** of the thyristor **140** and selectively provide a triggering current to the gate terminal **149** based on the voltage V_{thy} across the thyristor **140.** More specifically, the triggering circuit **150a** is configured to provide the current to the gate terminal of the thrystor when the voltage V_{thy} across the thyristor **140** exceeds a desired value, referred to as the desired triggering voltage V_{trig}. As such, the triggering circuit **150a** is designed to allow precise control over the operation of the thyristor **140.** For example, the triggering circuit **150a** may be configured to selectively provide the triggering current to the gate of the thyristor **140** when the voltage V_{thy} between the first and second terminals of the thyristor **140** is within about 0.1 V or less of the desired triggering voltage V_{trig}. Also, the operation of the triggering circuit **150a** is designed to be independent of the operating temperature of the device **100.** For example, the triggering voltage may be consistently provided over a range of about -40 °C to about 100 °C.

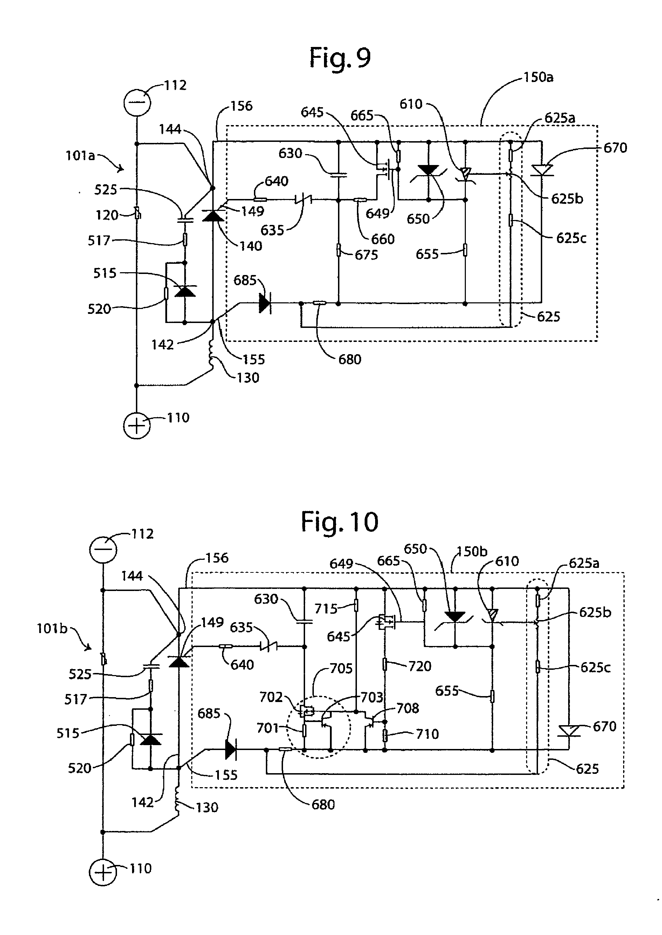

**Figure 9** illustrates the overvoltage protection circuit **101a** and the triggering circuit **150a** of **Figure 8** and related methods of operation in greater detail. As illustrated in **Figure 9**, the triggering circuit **150a** includes a capacitor **630** electrically connected to the gate terminal **149** of the thyristor **140,** and a bilateral voltage-triggered switch **635** electrically connected between the capacitor **630** and the gate terminal **149.** The voltage triggered switch **635** may be any suitable bidirectional switching device that is configured to conduct current when its breakdown voltage has been exceeded, such as a diode for alternating current (DIAC) and/or a silicon diode for alternating current (SIDAC). As such, the voltage triggered switch **635** is configured to discharge the capacitor **630** to provide the triggering current the gate terminal **149** of the thyristor **140** when the voltage of the capacitor **630** is greater than or equal to the breakdown voltage of the voltage-triggered switch **635.**

For example, as shown in **Figure 9,** the capacitor **630** may be charged through diode **685,** resistor **680,** and resistor **675** until the voltage reaches the breakdown voltage Vₜᵣᵢₚ of the voltage-triggered switch **635** (for example, about 79V to about 90 V). Then, the capacitor **630** may be discharged to the gate terminal **149** of the thyristor **140** through the voltage-triggered switch **635** and a current limiting resistor **640,** to trigger conduction of the thyristor **140.** The capacitor **630** may provide an exponential triggering current, with a suitably high peak value and duration to assure a fast and reliable triggering of the thyristor **140.** The diode **685** prevents reverse conduction of the triggering circuit **150a,** while a Zener diode **670** electrically connected to the main terminals **142, 144** of the thyristor **140** limits the voltage to a "safe" value for the triggering circuit **150a.**

Still referring to **Figure 9,** the triggering circuit **150a** includes a voltage comparator **610** and a voltage divider network **625**. The voltage divider network **625** is electrically connected to the positive and negative main terminals **142, 144** of the thyristor **140.** As such, the voltage comparator **610** is configured to monitor the voltage V_{thy} between the main terminals **142, 144** of the thyristor **140** based on an output voltage of a voltage divider network 625, to thereby determine when the voltage V_{thy} across the thyristor **140** exceeds the desired triggering voltage V_{trig}. Accordingly, when an output of the voltage comparator **610** indicates that the voltage V_{thy} across the thyristor **140** is greater than the desired triggering voltage V_{trig}, the triggering circuit **150a** may selectively charge the capacitor **630** to the breakdown voltage of the voltage-triggered switch **635,** to thereby provide the triggering current to the gate terminal **149** of the thyristor **140.**

More particularly, the voltage divider network **625** is configured to provide an output voltage to the voltage comparator **610** based on the voltage across the thyristor **140** and a predetermined voltage division ratio. The voltage divider network **625** includes a plurality of resistors **625a, 625b,** and **625c** that are electrically connected to the main terminals **142, 144** of the thyristor **140.** The values of the resistors **625a, 625b,** and **625c** may be chosen and/or adjusted to provide a desired voltage division ratio. For example, one or more of the resistors **625a, 625b,** and **625c** may be a potentiometer that is configured to provide an adjustable resistance, to thereby adjust the desired voltage division ratio. As such, an output voltage based on the voltage across the thyristor **140** and the voltage division ratio is provided to the voltage comparator **610.** The output voltage may be any voltage that is less than the voltage V_{thy} across the thyristor **140.** The voltage comparator **610** is configured to compare the output voltage of the voltage divider network **625** with a reference voltage in order to determine when the voltage V_{thy} between the positive and negative main terminals **142, 144** of the thyristor **140** is greater than the desired triggering voltage V_{trig}. For example, the reference voltage may be chosen based on the breakdown voltage of a zener diode **650** electrically connected to the voltage comparator **610**, as discussed below.

As illustrated in **Figure 9,** the triggering circuit **150a** further includes a N-channel field effect transistor (FET) **645.** The transistor **645** includes a gate terminal **649** electrically connected to the voltage comparator **610** and a resistor **665,** and at least one other terminal electrically connected to the capacitor **630.** As such, the transistor **645** is configured to bypass the capacitor **630** when the voltage V_{thy} across the thyristor **140** is less than the desired triggering voltage V_{trig}, to thereby prevent charging of the capacitor **630.** In addition, a zener diode **650** is electrically connected to the gate terminal **649** of the transistor **645** and the voltage comparator **610.** The zener diode **650** is configured to deactivate the transistor **645** when the voltage V_{thy} between the main terminals **142, 144** of the thyristor **140** is greater than the desired triggering voltage V_{trig}, to thereby allow charging of the capacitor **630.**

The operation of the transistor **645** and the zener diode **650** is controlled by the output of the voltage comparator **610,** to selectively provide the triggering current to the gate terminal **149** of the thyristor **140.** More particularly, when output of the voltage comparator **610** is less than the breakdown voltage of zener diode **650,** the zener diode **650** does not conduct current. As such, a gate voltage is provided to the gate terminal **649** of the transistor **645** to switch the transistor **645** to a conducting (*i.e.,* "on") state. Thus, current may flow through the diode **685,** the resistors **680, 675, 660,** and the transistor **645** to bypass the capacitor **630,** preventing the capacitor **630** from being charged. In contrast, when output of the voltage comparator **610** is greater than or equal to the breakdown voltage of zener diode **650,** the zener diode **650** conducts current, thereby short-circuiting the gate terminal **649** of the transistor **645** to switch the transistor **645** to a non-conducting (*i.e*., "off") state. Thus, current may flow through the diode **685** and the resistors **680** and **675** to charge the capacitor **630** to the breakdown voltage of the voltage-controlled switch **635,** thereby triggering the thyristor **140.**

The overvoltage protection circuit **101a** and the triggering circuit **150a** of **Figure 9** will now be described with reference to the following example. In this example, it is assumed that the desired triggering voltage V_{trig} to activate the thyristor **140** is 120V, and the breakdown voltage of the zener diode **650** is 12V. Accordingly, the values of the resistors **625a, 625b,** and **625c** of the voltage divider network **625** may be selected and/or adjusted to divide down the voltage V_{thy} such that the output of the voltage comparator **610** exceeds 12V only when the voltage V_{thy} across the thyristor is greater than V_{trig} (*i.e.,* greater than 120V). As such, if V_{thy} is less than 120V, the output of the voltage comparator **610** is less than 12V, and the zener diode **650** does not conduct. Thus, the output of the voltage comparator **610** (for example, 10V) is provided to the gate terminal **649** the transistor **645,** and the transistor **645** is switched on, bypassing the capacitor **630**. As such, charging of the capacitor **630** is prevented. On the other hand, if V_{thy} is greater than or equal to 120V, the output of the voltage comparator **610** is greater than or equal to 12V, and the zener diode **650** is reverse-biased, short-circuiting the gate terminal **649** of the transistor **645.** Thus, the transistor **645** is switched off, allowing charging of the capacitor **630**. When the capacitor **630** is charged to the breakdown voltage of the voltage-triggered switch **635,** the voltage-triggered switch **635** conducts, discharging the capacitor **630** to the gate terminal of the thyristor **140.** Accordingly, the thyristor **140** is activated to short the terminals **110** and **112** of the voltage source.

According to some embodiments, the device **100** may include an alternative overvoltage protection circuit **101b**. **Figure 10** illustrates an alternate overvoltage protection circuit **101b** including an alternate triggering circuit **150b** and related methods of operation according to further embodiments of the present invention. The triggering circuit **150b** may include many of the same components of the triggering circuit **150a** of **Figure 9,** and as such, like components may be illustrated by like numbers. Referring now to **Figure 10,** the triggering circuit 150b further includes a constant current source **705** electrically connected to the capacitor **630,** in place of the resistor **675** of **Figure 9.** The constant current source **705** may be selectively activated to provide the current to charge the capacitor **630** based on the voltage V_{thy} between the positive and negative main terminals **142, 144** of the thyristor **140.** More specifically, the constant current source **705** may be activated to charge the capacitor **630** when the voltage between the main terminals **142, 144** of the thyristor **140** is greater than the desired triggering voltage V_{trig}, and may be deactivated to prevent charging of the capacitor **630** when the voltage V_{thy} across the thyristor **140** is less than the desired triggering voltage V_{trig}.

In particular, as shown in **Figure 10,** the constant current source **705** includes a P-channel FET **702,** a resistor **701** connected to the source of the FET **702,** and a PNP transistor **703.** Additional resistors **710, 715,** and **720** are also provided to couple the constant current source **705** to the transistor **645**. The current provided by the current source **705** may be determined by the base-emitter voltage (V_{BE}) of the transistor **703** (for example, about 0.7V) divided by the value of the resistor **701.** A PNP transistor **708,** driven by the transistor **645,** activates or deactivates the current source **705** depending on whether the output of the voltage comparator **610** is greater than or less than the breakdown voltage of the zener diode **650,** as discussed above with reference to **Figure 9.**

As such, the constant current source **705** provides a current to charge the capacitor **630** (and thus, to trigger the thyristor **140)** only if the voltage V_{thy} across the thyristor **140** is equal or greater to V_{trig}. In comparison, in **Figure 9,** when the thyristor **140** is not conducting (*i.e.,* when V_{thy} is lower than V_{trig}), there may be substantial current flow through the series combination of resistors **660, 675,** and **680.** Accordingly, by employing the constant current source **705** of **Figure 10** to selectively turn-on the current to charge the capacitor **630,** the current flow through the resistors **660, 675,** and **680** can be reduced to a negligible value.

Accordingly, the overvoltage protection device **100** including the triggering circuit **150a** or **150b** of **Figures 8-10** offers various advantages over overvoltage protection devices of the prior art. In particular, the design of the voltage comparator **610** and the voltage divider network **625** of the triggering circuit **150a** or **150b** allows for more precise triggering of the thyristor **140.** According to some embodiments, the triggering circuit enables control of triggering of the thyristor **140** to within about 0.1 V or less of a desired triggering voltage V_{trig}.

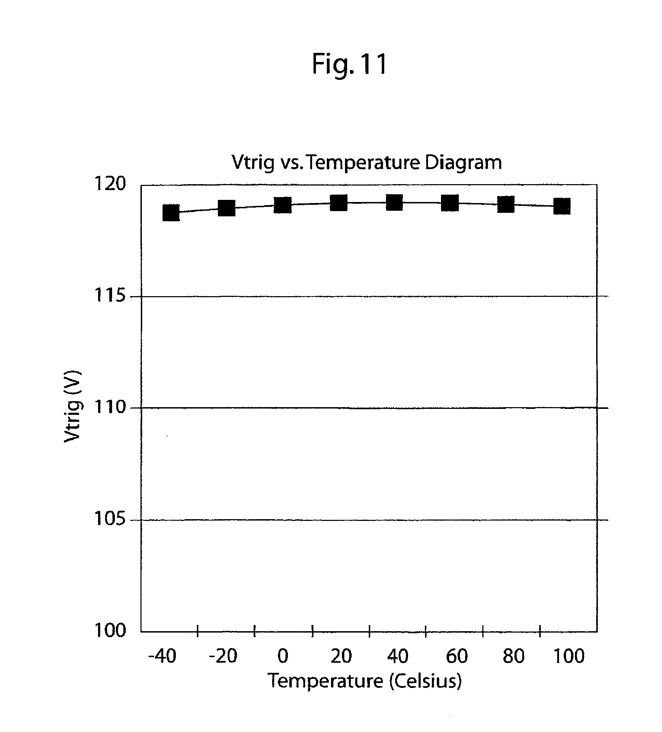

The voltage comparator **610** and the voltage divider network **625** of the triggering circuits **150a** and **150b** may also be designed to operate independently of the operating temperature of the voltage-limiting device **100.** According to some embodiments, the resistors **625a, 625b,** and **625c** of the voltage divider network **625** may be metal film resistors formed of the same material, or may be otherwise designed to provide a temperature-insensitive voltage division ratio. An exemplary variation of the desired triggering voltage V_{trig} as a function of temperature as may be provided by overvoltage protection circuits in accordance with embodiments of the present invention is illustrated in **Figure 11.** As shown in **Figure 11,** since the desired triggering voltage V_{trig} is determined by the reference voltage of the voltage comparator **610** and the temperature-insensitive voltage division ratio of the voltage divider network **625**, the voltage V_{trig} remains relatively constant over a range of about -40 °C to about 100 °C.

The module **100** as described above may be well-suited for use in a direct current (DC) powered network. According to some embodiments, the modules according to embodiments of the present invention may be adapted for use in alternating current (AC) powered networks. According to some embodiments, an overvoltage protection module for use in an AC network corresponds to the module 100 except that there are provided two thyristors and two triggering circuit assemblies (and hence, two triggering circuits). Each triggering circuit assembly is associated with a respective one of the thyristors to control operation of the respective thyristor as described above. The thyristor/triggering circuit pairs are electrically connected in parallel with one another such that each thyristor conducts current in a direction opposite to the other when an appropriate trigger signal is applied to the respective gate terminals of the thyristors. The thyristor/triggering circuit pairs are otherwise connected to the remainder of the electrical circuit in the same manner as described above. According to some embodiments, the thyristors are mounted side-by-side across the width of the pole plate. According to some embodiments, the two triggering circuits are mounted on a single PCB.

Many alterations and modifications may be made by those having ordinary skill in the art, given the benefit of present disclosure, without departing from the spirit and scope of the invention. Therefore, it must be understood that the illustrated embodiments have been set forth only for the purposes of example, and that it should not be taken as limiting the invention as defined by the following claims. The following claims, therefore, are to be read to include not only the combination of elements which are literally set forth but all equivalent elements for performing substantially the same function in substantially the same way to obtain substantially the same result. The claims are thus to be understood to include what is specifically illustrated and described above, what is conceptually equivalent, and also what incorporates the essential idea of the invention.

## Claims

1. A voltage limiting device, comprising:
a varistor device having first and second terminals;
a thyristor having first and second terminals respectively electrically connected to the first and second terminals of the varistor device; and
a triggering circuit electrically connected to a gate terminal of the thyristor and configured to monitor a voltage between the first and second terminals of the thyristor and selectively provide a triggering current to the gate terminal of the thyristor based on the voltage between the first and second terminals of the thyristor.

2. The device of Claim 1, wherein the triggering circuit comprises:
a voltage comparator configured to monitor the voltage between the first and second terminals of the thyristor and determine when the voltage between the first and second terminals of the thyristor exceeds a desired triggering voltage.

3. The device of Claim 2, wherein the triggering circuit further comprises:
a voltage divider network electrically connected to the thyristor and the voltage comparator and configured to provide an output voltage based on the voltage between the first and second terminals of the thyristor and a predetermined voltage division ratio,
wherein the voltage comparator is configured to monitor the voltage between the first and second terminals of the thyristor based on the voltage divider network output voltage.

4. The device of Claim 3, wherein the voltage comparator is further configured to compare the voltage divider network output voltage and a reference voltage to determine when the voltage between the first and second terminals of the thyristor is greater than the desired triggering voltage.

5. The device of Claim 3, wherein the voltage divider network comprises:
a plurality of resistors electrically connected to the first and second terminals of the thyristor and having respective resistance values selected to provide the predetermined voltage division ratio based on the desired triggering voltage.

6. The device of Claim 5, wherein at least one of the plurality of resistors comprises a potentiometer configured to provide an adjustable resistance based on the desired triggering voltage.

7. The device of Claim 3, wherein the voltage comparator and the voltage divider network are configured such that the reference voltage and the predetermined voltage division ratio are independent of an operating temperature of the voltage-limiting device.

8. The device of Claim 7, wherein the plurality of resistors comprises a plurality of metal film resistors formed of a same material.

9. The device of Claim 4, wherein the triggering circuit further comprises:
a capacitor electrically connected to the gate terminal of the thyristor; and
a bilateral voltage-triggered switch electrically connected between the capacitor and the gate of the thyristor and configured to discharge the capacitor to provide the triggering current when a voltage of the capacitor is greater than or equal to a breakdown voltage of the bilateral voltage-triggered switch,
wherein the triggering circuit is configured to selectively charge the capacitor responsive to an output of the voltage comparator indicating that the voltage between the first and second terminals of the thyristor is greater than the desired triggering voltage.

10. The device of Claim 9, wherein the triggering circuit further comprises:
a transistor having a gate terminal electrically connected to the voltage comparator and having at least one terminal electrically connected to the capacitor; and
a zener diode electrically connected to the transistor gate terminal and the voltage comparator;
wherein the voltage comparator is configured to bias the transistor to bypass the capacitor when the voltage between the first and second terminals of the thyristor is less than the desired triggering voltage to prevent charging of the capacitor,
and wherein the voltage comparator is configured to reverse-bias the zener diode to deactivate the transistor when the voltage between the first and second terminals of the thyristor is greater than the desired triggering voltage to selectively charge the capacitor.

11. The device of Claim 9, further comprising:
a constant current source electrically connected to the capacitor and configured to be activated to charge the capacitor when the voltage between the first and second terminals of the thyristor is greater than the desired triggering voltage and to be deactivated to prevent charging of the capacitor when the voltage between the first and second terminals of the thyristor is less than the desired triggering voltage.

12. The device of Claim 1, wherein the triggering circuit is configured to selectively provide the triggering current to the gate of the thyristor when the voltage between the first and second terminals thereof is within about 0.1 V or less of the desired triggering voltage.

13. The device of Claim 1, further comprising:
an inductive coil electrically connected between the first terminal of the thyristor and the first terminal of the varistor device and configured to maintain a predetermined current rate-of-change that is less than a maximum current rate-of-change specified for the thyristor.

14. The device of Claim 1, wherein the varistor device comprises:
a metal housing assembly and a metal oxide varistor wafer contained in the housing assembly.

15. The device of Claim 1, comprising an electronics assembly including the varistor device and the thyristor, the device further including a housing containing the electronics assembly, wherein the varistor device and the thyristor are disposed in the housing.

16. The device of Claim 15, wherein the electronics assembly includes an inductive coil electrically connected to the thyristor, wherein the inductive coil is disposed in the housing.

17. The device of Claim 15, wherein the housing includes:
an inner housing formed of a resin encapsulating at least or portion of the electronics assembly; and
an outer shell surrounding at least a portion of the inner housing and the electronics assembly.

18. The device of Claim 17, whererin the inner housing is formed of polyurethane and the outer shell is formed of polycarbonate.

19. The device of Claim 18, wherein the electronics assembly includes at least two electrical connection terminals extending outwardly beyond the housing, wherein the inner housing forms a seal about the at least two electrical connection terminals.

20. The device of Claim 17, further including a gas chamber defined between the electronics assembly and the inner housing to accommodate thermal expansion of the inner housing.

21. The device of Claim 20, further including a barrier film interposed between the gas chamber and the inner housing.

22. A method of operating a voltage limiting device including a varistor device and a thyristor electrically connected to the varistor device, the method comprising:
monitoring a voltage between first and second terminals of the thyristor; and
selectively providing a triggering current to a gate terminal of the thyristor when the voltage between the first and second terminals of the thyristor exceeds a desired triggering voltage.

23. The method of Claim 22, wherein monitoring the voltage comprises:
dividing the voltage between the first and second terminals of the thyristor using a voltage divider network having a predetermined voltage division ratio to provide a divided output voltage; and
monitoring the voltage between the first and second terminals of the thyristor based on the divided output voltage.

24. The method of Claim 23, further comprising:
comparing the divided output voltage and a reference voltage using a voltage comparator to determine when the voltage between the first and second terminals of the thyristor is greater than the desired triggering voltage.

25. The method of Claim 24, wherein selectively providing the triggering current comprises:
selectively charging a capacitor electrically connected to the gate terminal of the thyristor based on the comparison between the divided output voltage and the reference voltage to provide the triggering current.

26. A method for forming an overvoltage protection device module, the method comprising:
a) placing an electronics assembly in a shell cavity of a shell such that at least a portion of the electronics assembly is contained therein;
b) introducing a liquid filler resin into the shell cavity between the shell and the electronics assembly; and
c) curing the liquid filler resin to form an inner housing between the shell and the electronics assembly, wherein a gas chamber is defined between the inner housing and the electronics assembly.

27. The method of Claim 26 further including, prior to introducing the liquid filler resin, mounting a barrier film about the electronics assembly such that a volume of gas is trapped within the barrier film, and maintaining the volume of gas in the barrier film until the liquid filler resin is at least partially cured.

28. The method of Claim 26 wherein the inner housing is formed of polyurethane and the shell is formed of polycarbonate.

29. The method of Claim 26 including molding the shell prior to placing the electronics assembly in the cavity of the shell.

30. The method of Claim 26 wherein the electronics assembly includes:
a varistor device; and
a thyristor electrically connected in parallel with the varistor device.
